# EUROPEAN PATENT APPLICATION

(11) **EP 4 087 132 A1**
(43) Date of publication of application: **09.11.2022**
(21) Application number: 20910858.8
(22) Date of filing: 06.05.2020
(51) Int. Cl.: H03H 9/15

(54) **BULK ACOUSTIC RESONATOR SET, FILTER, ELECTRONIC DEVICE, ELECTROMECHANICAL COUPLING COEFFICIENT ADJUSTMENT METHOD**

(30) Priority: 31.12.2019 CN 201911419061
(71) Applicant: Rofs Microsystem (Tianjin) Co., Ltd, Tianjin 300462 (CN)
(72) Inventor: HAO, Long, Tianjin 300072 (CN); PANG, Wei, Tianjin 300072 (CN); XU, Yang, Tianjin 300462 (CN); ZHANG, Wei, Tianjin 300462 (CN); YANG, Qingrui, Tianjin 300072 (CN); ZHANG, Menglun, Tianjin 300072 (CN)
(74) Representative: Ström & Gulliksson AB
(86) International application number: PCT/CN2020/088719
(87) International publication number: WO 2021/135010

(57) **Abstract**

The present disclosure relates to a bulk acoustic resonator component, including at least two bulk acoustic resonators provided on a same substrate, each resonator including: an acoustic mirror; a bottom electrode; a top electrode; and a piezoelectric layer, an overlapping area of the acoustic mirror, the bottom electrode, the piezoelectric layer, and the top electrode in the thickness direction of the resonator constituting an effective area of the resonator, where: the at least two bulk acoustic resonators include a first resonator and a second resonator; the first resonator includes a first piezoelectric layer, the second resonator includes a second piezoelectric layer, the first piezoelectric layer and the second piezoelectric layer are of a same material and arranged in a same layer, and the thickness of the first piezoelectric layer is greater than the thickness of the second piezoelectric layer. The present disclosure also relates to an electromechanical coupling coefficient adjustment method, a filter comprising the bulk acoustic resonator set, and an electronic device.

## Description

### TECHNICAL FIELD

Embodiments of the present disclosure relate to the field of semiconductors, and in particular, to a bulk acoustic wave resonator assembly, a filter having the resonator assembly, an electronic device having the filter or the resonator assembly, and a method for adjusting an electromechanical coupling coefficient.

### BACKGROUND

The bulk acoustic wave filter is widely used in the current wireless communication systems due to its advantages of low insertion loss, high rectangular coefficient, high power capacity and the like, and is an important component to determine quality of a radio frequency signal transmitted into and from a communication system.

In the related art, electromechanical coupling coefficients of resonators with a same frequency on the same substrate is not adjustable. In general, when the frequency of the resonator is determined, an electromechanical coupling coefficient of the resonator is determined and cannot be adjusted.

However, resonators with the same frequency and different electromechanical coupling coefficients are frequently used in the actual application. Therefore, there is requirement in the related art that different resonators, for example two resonators, are provided on the same substrate, and have the same frequency and different electromechanical coupling coefficients.

### SUMMARY

In order to solve at least one aspect of the above technical problems in the related art, the present disclosure is provided.

According to an aspect of embodiments of the present disclosure, a bulk acoustic wave resonator assembly is provided and includes at least two bulk acoustic wave resonators provided on a same substrate. Each of the bulk acoustic wave resonators includes an acoustic mirror, a bottom electrode, a top electrode, and a piezoelectric layer. The acoustic mirror, the bottom electrode, the piezoelectric layer and the top electrode overlap with each other in a thickness direction of the resonator to form an overlapping region, the overlapping region is configured to be an effective region of the bulk acoustic wave resonator. The at least two bulk acoustic wave resonators includes a first resonator and a second resonator. The first resonator includes a first piezoelectric layer and the second resonator includes a second piezoelectric layer, the first piezoelectric layer and the second piezoelectric layer are arranged in a same layer, and a thickness of the first piezoelectric layer is greater than a thickness of the second piezoelectric layer.

According to another aspect of the embodiments of the present disclosure, a method of adjusting an electromechanical coupling coefficient is provided. The method includes: forming a common piezoelectric layer for a first bulk acoustic wave resonator and a second bulk acoustic wave resonator on a same substrate; and configuring a thickness of a second piezoelectric layer of the second bulk acoustic wave resonator to be smaller than a thickness of a first piezoelectric layer of the first bulk acoustic wave resonator, to adjust a difference between an electromechanical coupling coefficient of the first bulk acoustic wave resonator and an electromechanical coupling coefficient of the second bulk acoustic wave resonator.

According to another aspect of the embodiments of the present disclosure, there is provided a filter that includes the above bulk acoustic wave resonator assembly. Two bulk acoustic wave resonators of at least one the bulk acoustic wave resonator assembly have different electromechanical coupling coefficients.

An embodiment of the present disclosure further relates to an electronic device including the filter or the bulk acoustic wave resonator assembly as described above.

### BRIEF DESCRIPTION OF DRAWINGS

The following description and drawings can facilitate to understand these and other features and advantages in various embodiments disclosed in the present disclosure. The same reference signs in the drawings always indicate the same components.
FIG. 1 is a schematic sectional view of a bulk acoustic wave resonator assembly according to an exemplary embodiment of the present disclosure.
FIGS. 2A to 2D are schematic sectional views illustrating a manufacturing process of a bulk acoustic wave resonator assembly according to an exemplary embodiment of the present disclosure, in which an exemplary process of adjusting an electromechanical coupling coefficient is illustrated.
FIG. 3 is a schematic sectional view of a bulk acoustic wave resonator assembly according to an exemplary embodiment of the present disclosure, in which the top electrode is provided with a wing structure.
FIG. 4 is a schematic sectional view of a bulk acoustic wave resonator assembly according to an exemplary embodiment of the present disclosure, in which a gap layer is provided between a top electrode and a piezoelectric layer.
FIG. 5 is a schematic sectional view of a bulk acoustic wave resonator assembly according to an exemplary embodiment of the present disclosure, in which a top electrode is provided with a bridge structure.
FIG. 6 is a schematic sectional view of a bulk acoustic wave resonator assembly according to an exemplary embodiment of the present disclosure, in which a piezoelectric layer of a first resonator is formed by two piezoelectric layers with different materials.
FIGS. 7Ato 7E correspond to FIGS. 2 to 6, respectively, with difference in that there are further provided with protrusion-recess structures respectively in FIGS. 7Ato 7E.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

With current technologies, electromechanical coupling coefficients of resonators with the same frequency on the same substrate cannot be adjusted. In general, when the frequency of the resonator is determined, an electromechanical coupling coefficient of the resonator is determined and cannot be adjusted. In view of current design demands, it is required to use resonators that have different electromechanical coupling coefficients and the same frequency or a specific frequency difference. The present disclosure is to provide resonators with different electromechanical coupling coefficients on the same substrate while maintaining the same frequency or the specific frequency difference. Accordingly, there are advantages that design requirements are satisfied and design difficulty can be reduced. Designers have more options in designing, thus breaking limitation of a resonator frequency on the electromechanical coupling coefficient.

In addition, as described later, in the present disclosure, a thickness of a piezoelectric layer is controlled by trimming, such as bombardment by a beam of particles, for example, a target surface is bombarded by argon, so as to realize controlling of the electromechanical coupling coefficient. In the present disclosure, the thickness of the piezoelectric layer can be controlled accurately by trimming to obtain different piezoelectric layer thicknesses. This can achieve a simple process and a high accuracy. In the present disclosure, the frequency is compensated by thickening a trimmed top electrode of the resonator.

In addition, in the present disclosure, a piezoelectric layer of different materials can be configured to increase a difference between electromechanical coupling coefficients. In addition, a gap can be added in the resonator to further increase the difference of electromechanical coupling coefficients.

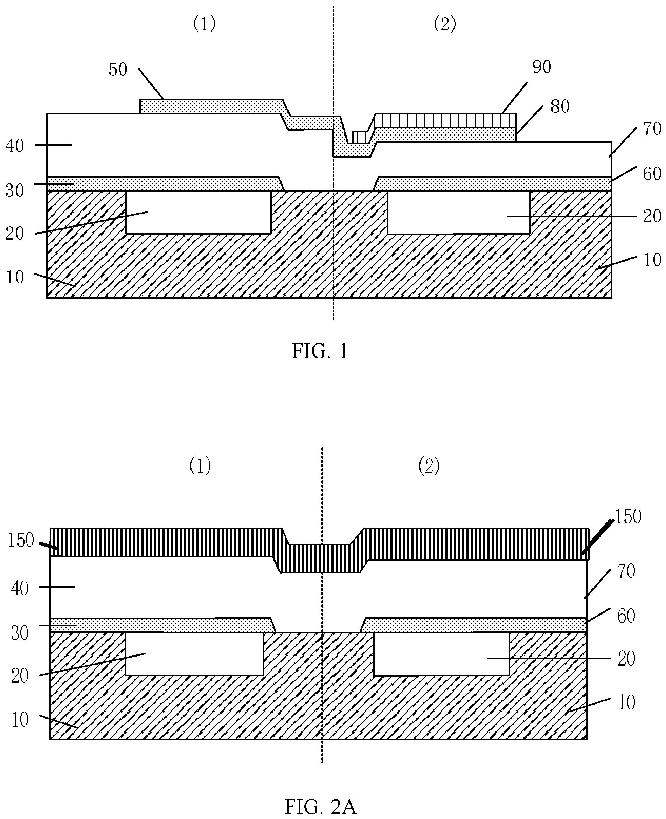

In FIGS. 1 to 2D, reference numbers are described as follows.
10: Substrate, which may be made of a material such as monocrystalline silicon, gallium arsenide, sapphire, and quartz.
20: Acoustic mirror, which may be a cavity, or may adopt a Bragg reflection layer and other equivalent forms. In an exemplary embodiment, the acoustic mirror is a cavity.
30 and 60: Bottom electrodes, which are made of a material such as molybdenum, ruthenium, gold, aluminum, magnesium, tungsten, copper, titanium, iridium, osmium, chromium, or composites or alloys thereof.
40 and 70: First piezoelectric film layers, which are made of a material such as aluminum nitride, zinc oxide, PZT, lithium niobate (LiNbO₃), auartz, potassium niobate (KNbO₃), or lithium tantalate (LiTaO₃), and contain the above materials doped with a certain atomic ratio of rare earth element.
50 and 80: Top electrodes, which are made of a material such as molybdenum, ruthenium, gold, aluminum, magnesium, tungsten, copper, titanium, iridium, osmium, chromium, or composites or alloys thereof.
90: Mass loading layer, which is made of a material such as molybdenum, ruthenium, gold, aluminum, magnesium, tungsten, copper, titanium, iridium, osmium, chromium, or composites or alloys thereof.
100 and 110: Air layers or gaps between the top electrode and the piezoelectric layer.
120: Second piezoelectric film layer, which is different from the first piezoelectric layers, and may be made of different materials based on different Kt requirements. The second piezoelectric film layer can be made of a material such as aluminum nitride, zinc oxide, and PZT, and contains the above materials doped with a certain atomic ratio of rare earth element.
130: First boundary layer, which is made of a material such as molybdenum, ruthenium, gold, aluminum, magnesium, tungsten, copper, titanium, iridium, osmium, chromium or composites or alloys thereof, or is made of a material such as aluminum nitride, zinc oxide, and PZT and contains the above materials doped with a certain atomic ratio of rare earth element.
140: Second boundary layer, which is made of a material such as molybdenum, ruthenium, gold, aluminum, magnesium, tungsten, copper, titanium, iridium, osmium, chromium or composites or alloys thereof, or is made of a material such as aluminum nitride, zinc oxide, and PZT and contains the above materials doped with a certain atomic ratio of rare earth element.
150: Barrier layer, which may be made of any material as long as it can prevent a thickness of a piezoelectric layer of a resonator 1 from being influenced, for example when a thickness of a piezoelectric layer of a resonator 2 is trimmed. For example, the barrier layer is at least partially maintained at an end of trimming, or for example when the piezoelectric layer of a second resonator or the resonator 2 is trimmed to a predetermined thickness, the barrier layer prevents the piezoelectric layer of the resonator 1 from being affected by trimming. The barrier layer can be further selected in such a manner that there is no excessive piezoelectric layer loss during the removing of the barrier layer.

FIG. 1 is a schematic sectional view of a bulk acoustic wave resonator assembly according to an exemplary embodiment of the present disclosure. In FIG. 1, the thickness of the piezoelectric layer 40 of the resonator 1 is greater than the thickness of the piezoelectric layer 70 of the resonator 2, and the piezoelectric layer 40 and the piezoelectric layer 70 are made of the same material during the simultaneous deposition and are arranged in the same layer. The "arranged in the same layer" means that bottom sides or lower sides of the two piezoelectric layers are arranged on the same plane or formed in the same piezoelectric layer forming step.

It should also be noted that, in an embodiment of the present disclosure, two resonators are provided on the same substrate, but the present disclosure is not limited to this. For example, more resonators can be provided on the same substrate as long as piezoelectric layers of the resonators are arranged in the same layer.

It should be noted that if it is desired to realize this kind of piezoelectric layers with different thicknesses, an etching method is commonly used, but there are many problems for the etching. For example, an etching accuracy cannot be guaranteed. If a thickness is controlled by controlling etching time, the process is greatly limited and there are high requirements for an etching speed and tools. Meanwhile, chemical reactions occur during the etching, which affects quality of the piezoelectric layer.

As shown in FIG. 1, the resonators 1 and 2 are arranged on the same substrate. The resonator 2 is trimmed after the first piezoelectric film layer 40 is deposited and a position of the resonator 1 is shielded, to obtain a relatively thin piezoelectric layer 70. Top electrodes are then deposited, i.e. a top electrode 50 of the resonator 1 and a top electrode 80 of the resonator 2. In order to configure the resonator 2 and the resonator 1 to have the same frequency or a specific frequency difference, a mass loading layer 90 is further deposited on the resonator 2. A frequency of the resonator 2 can be adjusted by controlling a thickness of the load layer 90. Accordingly, adjustment of the electromechanical coupling coefficient is no longer limited by the frequency.

In the present disclosure, the trimming is to physically bombard a target surface with argon. There is no chemical reaction in this bombardment, and a controlling accuracy is relatively high, and a thickness accuracy is controlled to be within 3%. For example, a target is required to be trimmed by 100 Å, in which a range of 7 Å to 10000 Å is a range suitable for trimming. If the trimming range exceeds beyond this range, the processing time may be too long, such that partial etching and trimming are used in combination. In an embodiment, the target actually is trimmed by a range of 100 Å +/-3 Å, which can achieved a controlling accuracy superior to etching.

In addition, multiple trimming can be obtained by a trimming machine to realize on-chip uniformity compensation. The particle beam is used to bombard the target during the trimming and has a diameter of about 13 mm. Accordingly, compensation can be made according to thickness data during the trimming if in-plane uniformity is not good when depositing piezoelectric materials. For example, more trimming is performed in thick portions, and less trimming is performed in thin portions.

FIGS. 2A to 2D are schematic sectional views illustrating a manufacturing process of a bulk acoustic wave resonator assembly according to an exemplary embodiment of the present disclosure, and show an exemplary process of adjusting an electromechanical coupling coefficient. Referring to FIGS. 2A to 2D, a method of adjusting electromechanical coupling coefficients of the resonator 1 and the resonator 2 by realizing thickness difference between piezoelectric layers of the two resonators will be described below.

Firstly, as shown in FIG. 2A, a barrier layer 150 is formed on the piezoelectric layers after the piezoelectric layers are integrally formed, and a material of the barrier layer is not specifically limited. In a more specific embodiment, a thickness of the barrier layer is controlled in such a manner that the barrier layer is not completely trimmed at the end of trimming. In addition, it is also required to consider etching of the barrier layer and the piezoelectric layer when the barrier layer is subsequently removed, and for example etching of the piezoelectric layer is avoided or reduced when the barrier layer is etched.

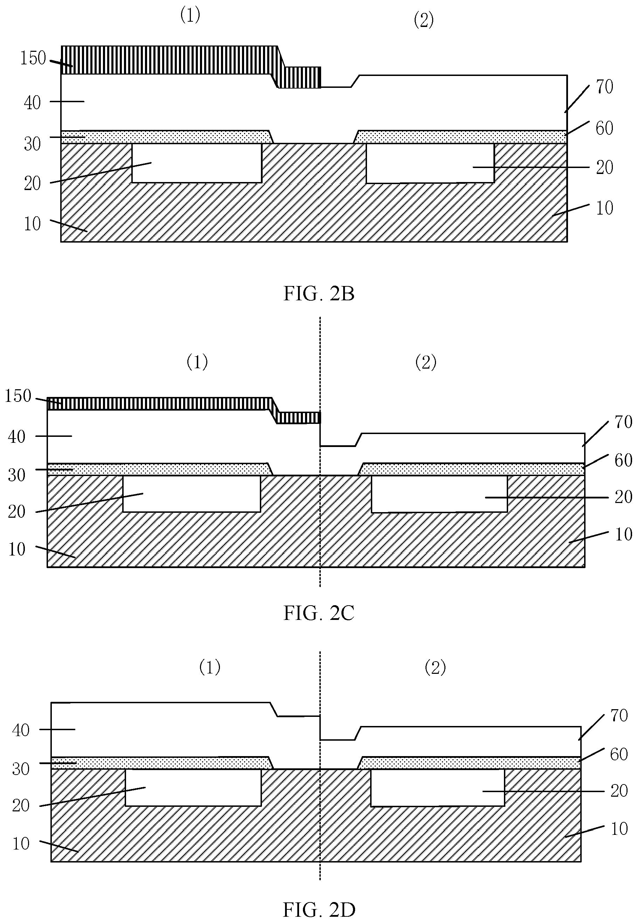

Secondly, as shown in FIG. 2B, a portion of the barrier layer 150 located on the resonator 2 is etched off by photolithography and etching, such that the piezoelectric layer 70 of the resonator 2 is exposed and a surface of the resonator 1 is configured to be the barrier layer 150. In this way, the piezoelectric material of the resonator 2 is trimmed during the trimming, an only the barrier layer 150 of the resonator 1 is consumed.

Thirdly, as shown in FIG. 2C, the trimming is performed. A part of the piezoelectric layer 70 of the resonator 2 is removed, and a part of the barrier layer 150 of the resonator 1 is removed.

Finally, as shown in FIG. 2D, the barrier layer 150 is removed by a dry or wet method, and it is required to fully consider influence on the piezoelectric layer when the barrier layer is removed either by the dry method or wet method. A structure after the barrier layer 150 is removed is shown in FIG. 2D.

As can be understood by those skilled in the art, the top electrode can be provided on the piezoelectric layer, and then the mass loading layer 90 can be provided on the top electrode of the resonator 2, to form a structure shown in FIG. 1.

The thickness of the piezoelectric layer is adjusted such that the thickness difference between the piezoelectric layers of the two resonators is a predetermined value, the electromechanical coupling coefficients of the two resonators can be adjusted.

In view of this, the electromechanical coupling coefficients of the two resonators are further adjusted in the present disclosure. For example, a bridge structure or a wing structure is provided at a non-pin end of the top electrode.

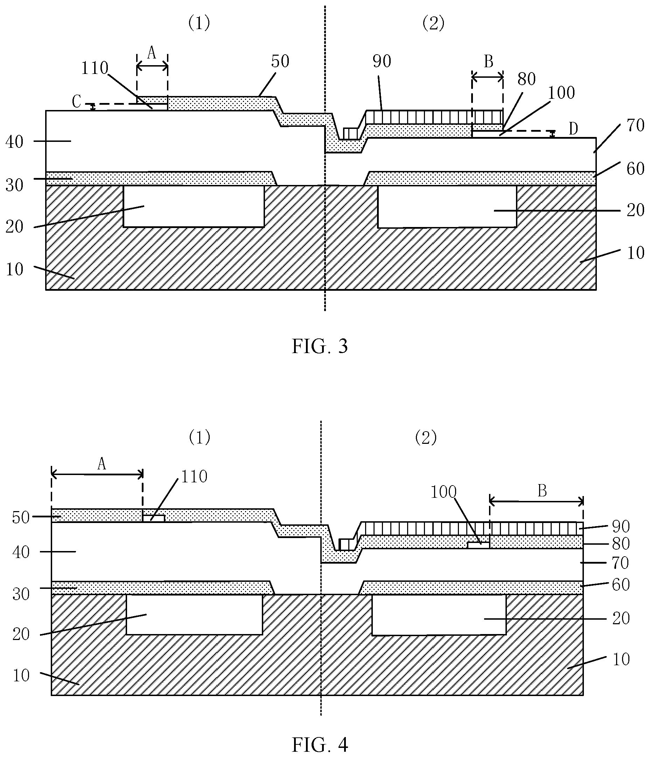

FIG. 3 is a schematic sectional view of a bulk acoustic wave resonator assembly according to an exemplary embodiment of the present disclosure, in which a top electrode is provided with a bridge structure.

The electromechanical coupling coefficients can be controlled by controlling thicknesses C and D and dimensions A and B of the air layers or gap layers 100 and 110 between the top electrodes and the piezoelectric layers, to obtain a larger difference between the electromechanical coupling coefficients. In other words, the electromechanical coupling coefficients of the resonators can be adjusted by adjusting widths A and B and/or heights C and D of the bridges of the resonator.

In the present disclosure, the gap layer may be filled with a non-conductive medium, such as silicon dioxide.

In an exemplary embodiment of the present disclosure, the height of the bridge structure is in a range of 100 Å to 4000 Å, such as 100 Å, 500 Å, 2400 Å, and 3000 Å.

In an exemplary embodiment of the present disclosure, the width of the bridge structure is in a range of 0.5 µm to 7 µm, such as 0.5 µm, 0.6 µm, and 0.7 µm.

Specifically, for either of the resonator 1 and the resonator 2, the heights of the bridge structure are constant, so that an electromechanical coupling coefficient of a corresponding resonator is decreased by increasing the width of the bridge structure, or the electromechanical coupling coefficient of the corresponding resonator is increased by decreasing the width of the bridge structure.

Alternatively, for either of the resonator 1 and the resonator 2, the widths of the bridge structure re constant, so that the electromechanical coupling coefficient of the corresponding resonator is increased by increasing the height of the bridge structure, or the electromechanical coupling coefficient of the corresponding resonator is decreased by decreasing the height of the bridge structure.

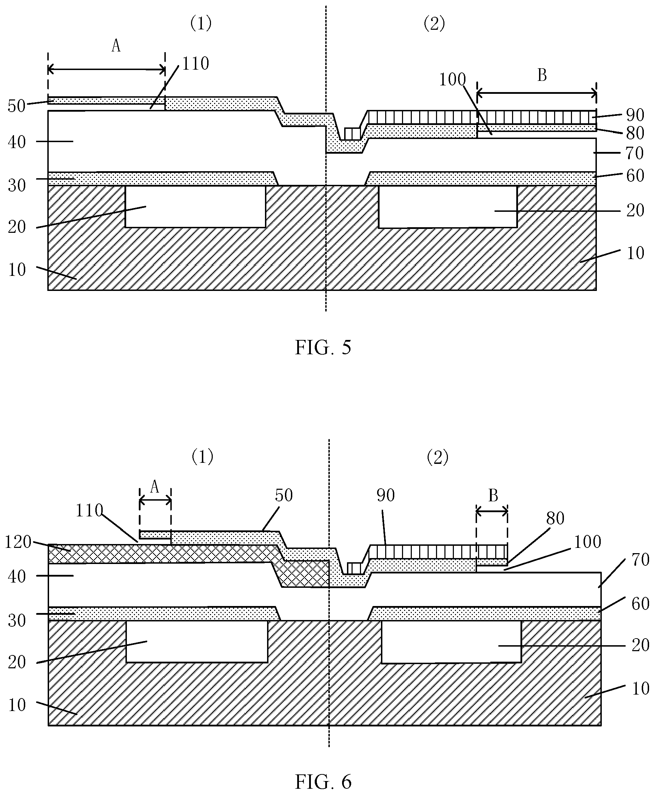

FIG. 5 is a schematic sectional view of a bulk acoustic wave resonator assembly according to an exemplary embodiment of the present disclosure, in which a top electrode is provided with a bridge structure. FIG. 5 differs from FIG. 3 in that the widths of the bridge structures are different from each other. In FIG. 5, the gap under the bridge structure extends beyond an edge of the cavity of the acoustic mirror.

FIG. 4 is a schematic sectional view of a bulk acoustic wave resonator assembly according to an exemplary embodiment of the present disclosure, in which gap layers 100 and 110 are provided between a top electrode and a piezoelectric layer. The gap layer is provided to adjust an electromechanical coupling coefficient of a resonator where it is located. As shown in FIG. 4, an electromechanical coupling coefficient of a resonator where a respective gap layer is located can be adjusted by controlling or selecting a corresponding parameter A of the gap layer.

In order to obtain greater difference between the electromechanical coupling coefficients, different materials for the piezoelectric layer can be used. FIG. 6 is a schematic sectional view of a bulk acoustic wave resonator assembly according to an exemplary embodiment of the present disclosure, in which a piezoelectric layer of a first resonator is formed of two piezoelectric layers with different materials. As shown in FIG. 6, first piezoelectric film layers 40 and 70 are prepared simultaneously. After the first piezoelectric film layers are formed, a second piezoelectric film layer 120 of another material is prepared. If a thickness of the piezoelectric film layer 120 is constant, the greater material velocity difference between the piezoelectric film layer 120 and the piezoelectric film layers 40 and 70 is, the greater the difference between the electromechanical coupling coefficients is.

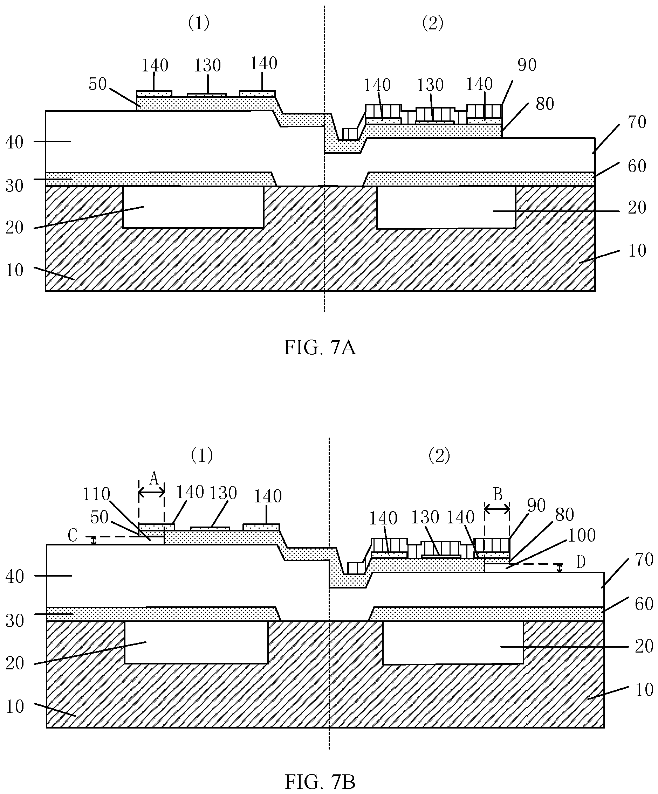

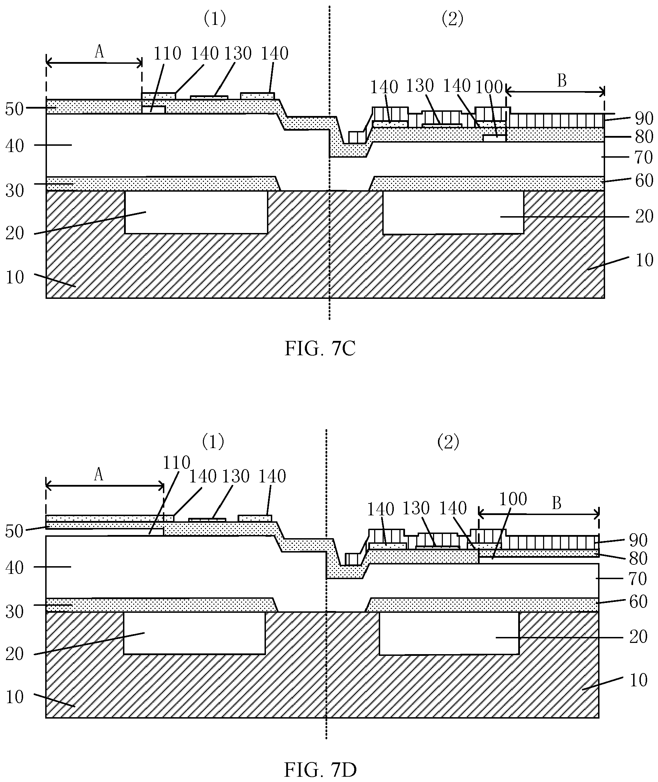

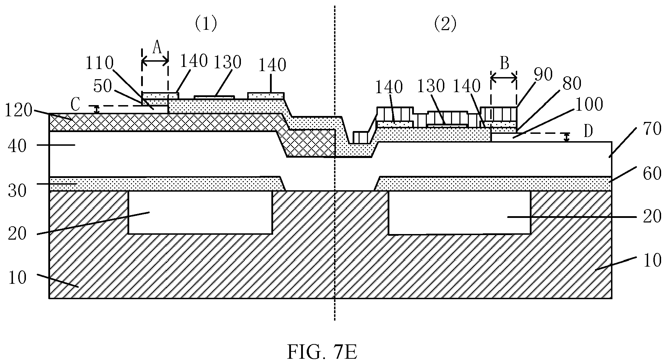

FIGS. 7A to 7E correspond to FIGS. 2 to 6 respectively, with difference that in FIGS. 7A to 7E, there are further provided protrusion-recess structures or boundary conditions, respectively. As shown in FIGS. 7A to 7E, the first boundary layer 130 and the second boundary layer 140 may be arranged above or below the top electrodes 50 and 80, and both the first boundary layer 130 and the second boundary layer 140 can be used separately.

In view of the above, the present disclosure provides following technical solutions.
1. A bulk acoustic wave resonator assembly includes at least two bulk acoustic wave resonators provided on a same substrate, each of the at least two resonators includes an acoustic mirror, a bottom electrode, a top electrode, and a piezoelectric layer, and the acoustic mirror, the bottom electrode, the piezoelectric layer and the top electrode overlap with each other in a thickness direction of the resonator to form an overlapping region, the overlapping region is configured to be an effective region of the resonator, wherein
   the at least two bulk acoustic wave resonators includes a first resonator and a second resonator; and
   the first resonator includes a first piezoelectric layer and the second resonator includes a second piezoelectric layer, the first piezoelectric layer and the second piezoelectric layer are arranged in a same layer, and a thickness of the first piezoelectric layer is greater than a thickness of the second piezoelectric layer.

2. The assembly according to 1, wherein
the second resonator further includes a mass loading layer; or
the first resonator and the second resonator each include a mass loading layer, and a thickness of the mass loading layer of the first resonator is smaller than a thickness of the mass loading layer of the second resonator.
3. The assembly according to 1 or 2, wherein
   the top electrode of the first resonator is provided with a first bridge structure at a non-pin end thereof, the first bridge structure has a first height and a first width, and a gap or a non-conductive dielectric layer is provided between the first bridge structure and the piezoelectric layer; and/or
   the top electrode of the second resonator is provided with a second bridge structure at a non-pin end thereof, the second bridge structure has a second height and a second width, and a gap or a non-conductive dielectric layer is provided between the second bridge structure and the piezoelectric layer.
4. The assembly according to 3, wherein
   the first height is different from the second height, and/or the first width is different from the second width.
5. The assembly according to 4, wherein
   the first height is different from the second height, and the first height and the second height are both in a range of 100 Å to 4000 Å; and/or
   the first width is different from the second width, and the first width and the second width are both in a range of 0.2 µm to 7 µm.
6. The assembly according to 1 or 2, wherein
   the first resonator includes a first gap structure provided between the top electrode and the piezoelectric layer of the first resonator and arranged within the effective region; and/or
   the second resonator includes a second gap structure provided between the top electrode and the piezoelectric layer of the second resonator and arranged within the effective region.
7. The assembly according to any one of 1 to 6, wherein
   the first piezoelectric layer includes a first piezoelectric sublayer and a second piezoelectric sublayer, the second piezoelectric sublayer is located above or below the first piezoelectric sublayer, and the first piezoelectric sublayer is made of a material different from a material of the second piezoelectric sublayer.
8. The assembly according to any one of 1 to 7, wherein
   the first resonator and/or the second resonator further include a protrusion structure and/or a recess structure near a boundary of the effective region.
9. A method of adjusting an electromechanical coupling coefficient includes:
   forming a common piezoelectric layer for a first bulk acoustic wave resonator and a second bulk acoustic wave resonator on a same substrate; and
   configuring a thickness of a second piezoelectric layer of the second bulk acoustic wave resonator to be smaller than a thickness of a first piezoelectric layer of the first bulk acoustic wave resonator, to adjust a difference between an electromechanical coupling coefficient of the first bulk acoustic wave resonator and an electromechanical coupling coefficient of the second bulk acoustic wave resonator.
10. The method according to 9 further includes:
   adjusting a frequency difference between the first bulk acoustic wave resonator and the second bulk acoustic wave resonator.
11. The method according to 10, wherein
   the adjusting the frequency difference between the first bulk acoustic wave resonator and the second bulk acoustic wave resonator includes providing a mass loading layer on the second bulk acoustic wave resonator to adjust a frequency of the second bulk acoustic wave resonator.
12. The method according to 10 or 11, wherein
   the adjusting the frequency difference between the first bulk acoustic wave resonator and the second bulk acoustic wave resonator includes adjusting at least one of the frequency of the second bulk acoustic wave resonator and the frequency of the first bulk acoustic wave resonator in such a manner that the frequency of the second bulk acoustic wave resonator and the frequency of the first bulk acoustic wave resonator are the same or the frequency difference between the second bulk acoustic wave resonator and the first bulk acoustic wave resonator is configured to be a predetermined value.
13. The method according to any one of 9 to 12, wherein
   the configuring the thickness of the second piezoelectric layer of the second bulk acoustic wave resonator to be smaller than the thickness of the first piezoelectric layer of the first bulk acoustic wave resonator includes:
   depositing a barrier layer on the common piezoelectric layer of the first bulk acoustic wave resonator and the second bulk acoustic wave resonator;
   removing a part of the barrier layer located on a portion of the piezoelectric layer corresponding to the second bulk acoustic wave resonator; and
   thinning the barrier layer on the first bulk acoustic wave resonator and the portion of the piezoelectric layer corresponding to the second bulk acoustic wave resonator until the piezoelectric layer corresponding to the second bulk acoustic wave resonator is reduced in thickness to be a second piezoelectric layer with a predetermined thickness.
14. The method according to 13 further includes:
   removing a remaining portion of the barrier layer from the piezoelectric layer of the first bulk acoustic wave resonator.
15. The method according to any one of 9 to 12, wherein
   the configuring the thickness of the second piezoelectric layer of the second bulk acoustic wave resonator to be smaller than the thickness of the first piezoelectric layer of the first bulk acoustic wave resonator includes:
      depositing a bottom electrode and a piezoelectric layer with a predetermined thickness on portions of the substrate corresponding to the first bulk acoustic wave resonator and the second bulk acoustic wave resonator, respectively; and
      depositing an additional piezoelectric layer on the piezoelectric layer of the first bulk acoustic wave resonator, the additional piezoelectric layer being made of a material different from a material of the piezoelectric layer of the first bulk acoustic wave resonator; or
   the configuring the thickness of the second piezoelectric layer of the second bulk acoustic wave resonator to be smaller than the thickness of the first piezoelectric layer of the first bulk acoustic wave resonator includes:
      depositing a bottom electrode, a piezoelectric layer, an additional piezoelectric layer and a barrier layer on portions of the substrate corresponding to the first bulk acoustic wave resonator and the second bulk acoustic wave resonator respectively, the piezoelectric layer being made of a material different from a material of the additional piezoelectric layer;
      removing the barrier layer of the second bulk acoustic wave resonator;
      thinning the barrier layer on the first bulk acoustic wave resonator and the additional piezoelectric layer on the second bulk acoustic wave resonator until the additional piezoelectric layer on the second bulk acoustic wave resonator is completely removed; and
      removing the barrier layer on the first bulk acoustic wave resonator.
16. The method according to any one of 9 to 15, wherein
   the method includes depositing a top electrode on upper surfaces of the piezoelectric layers of the first bulk acoustic wave resonator and the second bulk acoustic wave resonator; and
   the depositing the top electrode includes:
      providing a first bridge structure at a non-pin end of the top electrode of the first bulk acoustic wave resonator, the first bridge structure having a first height and a first width, and providing a medium between the first bridge structure and the piezoelectric layer; and/or
      providing a second bridge structure at a non-pin end of the top electrode of the second bulk acoustic wave resonator, the second bridge structure having a second height and a second width, and providing a gap or a non-conductive dielectric layer between the second bridge structure and the piezoelectric layer.
17. The method according to 16 includes:
   adjusting, by adjusting at least one of the first height and the second height and/or at least one of the first width and the second width and/or by selecting non-conductive dielectric with different dielectric constants, an electromechanical coupling coefficient of one corresponding resonator of the first bulk acoustic wave resonator and the second bulk acoustic wave resonator.
18. The method according to 17, wherein
   in each of the first bulk acoustic wave resonator and the second bulk acoustic wave resonator, the height of the bridge structure is constant, the electromechanical coupling coefficient of the corresponding bulk acoustic wave resonator is decreased by increasing the width of the bridge structure, or the electromechanical coupling coefficient of the corresponding bulk acoustic wave resonator is increased by decreasing the width of the bridge structure.
19. The method according to 17, wherein
   in each of the first bulk acoustic wave resonator and the second bulk acoustic wave resonator, the width of the bridge structure is constant, the electromechanical coupling coefficient of the corresponding bulk acoustic wave resonator is increased by increasing the height of the bridge structure, or the electromechanical coupling coefficient of the corresponding bulk acoustic wave resonator is decreased by decreasing the height of the bridge structure.
20. The method according to any one of 9 to 15, wherein
   the method includes depositing a top electrode on upper surfaces of the piezoelectric layers of the first bulk acoustic wave resonator and the second bulk acoustic wave resonator; and
   the depositing the top electrode includes:
      providing a first gap structure between the top electrode and the piezoelectric layer of the first bulk acoustic wave resonator within an effective region; and/or
      providing a second gap structure between the top electrode and the piezoelectric layer of the second bulk acoustic wave resonator within the effective region.
21. The method according to any one of 9 to 20 further includes:
   providing a protrusion structure and/or recess structure near a boundary of an effective region of the first bulk acoustic wave resonator and/or the second bulk acoustic wave resonator.
22. The method according to any one of 9 to 20, wherein
   in the configuring the thickness of the second piezoelectric layer of the second bulk acoustic wave resonator to be smaller than the thickness of the first piezoelectric layer of the first bulk acoustic wave resonator, a target surface is bombarded with a particle beam to adjust a thickness of a target piezoelectric layer of the first piezoelectric layer and the second piezoelectric layer.
23. The method according to 22, wherein
   a thickness range of the target piezoelectric layer removed by the particle beam bombardment is 7 Å to 10000 Å.
24. A filter includes the bulk acoustic wave resonator assembly according to any one of 1 to 8, two bulk acoustic wave resonators of at least one the bulk acoustic wave resonator assembly have different electromechanical coupling coefficients.
25. The filter according to 24, wherein
   the two bulk acoustic wave resonators in the at least one bulk acoustic wave resonator assembly have a same frequency, or a frequency difference between frequencies of the two bulk acoustic wave resonators is configured to be a predetermined value.
26. An electronic device includes the filter according to 24 or 25 or the bulk acoustic wave resonator assembly according to any one of 1 to 8.
The electronic device herein includes, but is not limited to, an intermediate product such as an RF front end, a filtering and amplifying module; and a terminal product such as a mobile phone, WIFI and a drone.
Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A bulk acoustic wave resonator assembly, comprising:
at least two bulk acoustic wave resonators provided on a same substrate, each of the at least two bulk acoustic wave resonators comprising an acoustic mirror, a bottom electrode, a top electrode, and a piezoelectric layer, and the acoustic mirror, the bottom electrode, the piezoelectric layer and the top electrode overlapping with each other in a thickness direction of the bulk acoustic wave resonator to form an overlapping region, the overlapping region being configured to be an effective region of the bulk acoustic wave resonator,
wherein the at least two bulk acoustic wave resonators comprises a first resonator and a second resonator; and
wherein the first resonator comprises a first piezoelectric layer and the second resonator comprises a second piezoelectric layer, the first piezoelectric layer and the second piezoelectric layer are arranged in a same layer, and a thickness of the first piezoelectric layer is greater than a thickness of the second piezoelectric layer.

2. The assembly according to claim 1, wherein the second resonator further comprises a mass loading layer; or
the first resonator and the second resonator each comprise a mass loading layer, and a thickness of the mass loading layer of the first resonator is smaller than a thickness of the mass loading layer of the second resonator.

3. The assembly according to claim 1 or 2, wherein the top electrode of the first resonator is provided with a first bridge structure at a non-pin end thereof, the first bridge structure has a first height and a first width, and a gap or a non-conductive dielectric layer is provided between the first bridge structure and the piezoelectric layer; and/or
the top electrode of the second resonator is provided with a second bridge structure at a non-pin end thereof, the second bridge structure has a second height and a second width, and a gap or a non-conductive dielectric layer is provided between the second bridge structure and the piezoelectric layer.

4. The assembly according to claim 3, wherein the first height is different from the second height, and/or the first width is different from the second width.

5. The assembly according to claim 4, wherein the first height is different from the second height, and the first height and the second height are both in a range of 100 Å to 4000 Å; and/or
the first width is different from the second width, and the first width and the second width are both in a range of 0.2 µm to 7 µm.

6. The assembly according to claim 1 or 2, wherein the first resonator comprises a first gap structure, the first gap structure is provided between the top electrode and the piezoelectric layer of the first resonator and arranged within the effective region; and/or
the second resonator comprises a second gap structure, the second gap structure is provided between the top electrode and the piezoelectric layer of the second resonator and arranged within the effective region.

7. The assembly according to any one of claims 1 to 6, wherein the first piezoelectric layer comprises a first piezoelectric sublayer and a second piezoelectric sublayer, the second piezoelectric sublayer is located above or below the first piezoelectric sublayer, and the first piezoelectric sublayer is made of a material different from a material of the second piezoelectric sublayer.

8. The assembly according to any one of claims 1 to 7, wherein the first resonator and/or the second resonator further comprise a protrusion structure and/or a recess structure near a boundary of the effective region.

9. A method of adjusting an electromechanical coupling coefficient, comprising:
forming a common piezoelectric layer for a first bulk acoustic wave resonator and a second bulk acoustic wave resonator on a same substrate; and
configuring a thickness of a second piezoelectric layer of the second bulk acoustic wave resonator to be smaller than a thickness of a first piezoelectric layer of the first bulk acoustic wave resonator, to adjust a difference between an electromechanical coupling coefficient of the first bulk acoustic wave resonator and an electromechanical coupling coefficient of the second bulk acoustic wave resonator.

10. The method according to claim 9, further comprising:
adjusting a frequency difference between the first bulk acoustic wave resonator and the second bulk acoustic wave resonator.

11. The method according to claim 10, wherein the adjusting the frequency difference between the first bulk acoustic wave resonator and the second bulk acoustic wave resonator comprises:
providing a mass loading layer on the second bulk acoustic wave resonator to adjust a frequency of the second bulk acoustic wave resonator.

12. The method according to claim 10 or 11, wherein the adjusting the frequency difference between the first bulk acoustic wave resonator and the second bulk acoustic wave resonator comprises:
adjusting at least one of the frequency of the second bulk acoustic wave resonator and the frequency of the first bulk acoustic wave resonator, in such a manner that the frequency of the second bulk acoustic wave resonator and the frequency of the first bulk acoustic wave resonator are the same or the frequency difference between the second bulk acoustic wave resonator and the first bulk acoustic wave resonator is configured to be a predetermined value.

13. The method according to any one of claims 9 to 12, wherein the configuring the thickness of the second piezoelectric layer of the second bulk acoustic wave resonator to be smaller than the thickness of the first piezoelectric layer of the first bulk acoustic wave resonator comprises:
depositing a barrier layer on the common piezoelectric layer of the first bulk acoustic wave resonator and the second bulk acoustic wave resonator;
removing a part of the barrier layer located on a portion of the piezoelectric layer corresponding to the second bulk acoustic wave resonator; and
thinning the barrier layer on the first bulk acoustic wave resonator and the portion of the piezoelectric layer corresponding to the second bulk acoustic wave resonator until the piezoelectric layer corresponding to the second bulk acoustic wave resonator is reduced in thickness to be a second piezoelectric layer with a predetermined thickness.

14. The method according to claim 13, further comprising:
removing a remaining portion of the barrier layer from the piezoelectric layer of the first bulk acoustic wave resonator.

15. The method according to any one of claims 9 to 12, wherein the configuring the thickness of the second piezoelectric layer of the second bulk acoustic wave resonator to be smaller than the thickness of the first piezoelectric layer of the first bulk acoustic wave resonator comprises:
depositing a bottom electrode and a piezoelectric layer with a predetermined thickness on portions of the substrate corresponding to the first bulk acoustic wave resonator and the second bulk acoustic wave resonator, respectively; and
depositing an additional piezoelectric layer on the piezoelectric layer of the first bulk acoustic wave resonator, the additional piezoelectric layer being made of a material different from a material of the piezoelectric layer of the first bulk acoustic wave resonator; or
the configuring the thickness of the second piezoelectric layer of the second bulk acoustic wave resonator to be smaller than the thickness of the first piezoelectric layer of the first bulk acoustic wave resonator comprises:
depositing a bottom electrode, a piezoelectric layer, an additional piezoelectric layer and a barrier layer on portions of the substrate corresponding to the first bulk acoustic wave resonator and the second bulk acoustic wave resonator respectively, the piezoelectric layer being made of a material different from a material of the additional piezoelectric layer;
removing the barrier layer of the second bulk acoustic wave resonator;
thinning the barrier layer on the first bulk acoustic wave resonator and the additional piezoelectric layer on the second bulk acoustic wave resonator until the additional piezoelectric layer on the second bulk acoustic wave resonator is completely removed; and removing the barrier layer on the first bulk acoustic wave resonator.

16. The method according to any one of claims 9 to 15, further comprising:
depositing a top electrode on upper surfaces of the piezoelectric layers of the first bulk acoustic wave resonator and the second bulk acoustic wave resonator; and
the depositing the top electrode comprises:
providing a first bridge structure at a non-pin end of the top electrode of the first bulk acoustic wave resonator, the first bridge structure having a first height and a first width, and providing a medium between the first bridge structure and the piezoelectric layer; and/or
providing a second bridge structure at a non-pin end of the top electrode of the second bulk acoustic wave resonator, the second bridge structure having a second height and a second width, and providing a gap or a non-conductive dielectric layer between the second bridge structure and the piezoelectric layer.

17. The method according to claim 16, further comprising:
adjusting, by adjusting at least one of the first height and the second height and/or at least one of the first width and the second width and/or by selecting non-conductive dielectric with different dielectric constants, an electromechanical coupling coefficient of one corresponding resonator of the first bulk acoustic wave resonator and the second bulk acoustic wave resonator.

18. The method according to claim 17, wherein in each of the first bulk acoustic wave resonator and the second bulk acoustic wave resonator, the height of the bridge structure is constant, the electromechanical coupling coefficient of the corresponding bulk acoustic wave resonator is decreased by increasing the width of the bridge structure, or the electromechanical coupling coefficient of the corresponding bulk acoustic wave resonator is increased by decreasing the width of the bridge structure.

19. The method according to claim 17, wherein in each of the first bulk acoustic wave resonator and the second bulk acoustic wave resonator, the width of the bridge structure is constant, the electromechanical coupling coefficient of the corresponding bulk acoustic wave resonator is increased by increasing the height of the bridge structure, or the electromechanical coupling coefficient of the corresponding bulk acoustic wave resonator is decreased by decreasing the height of the bridge structure.

20. The method according to any one of claims 9 to 15, further comprising:
depositing a top electrode on upper surfaces of the piezoelectric layers of the first bulk acoustic wave resonator and the second bulk acoustic wave resonator; and
the depositing the top electrode comprises:
providing a first gap structure between the top electrode and the piezoelectric layer of the first bulk acoustic wave resonator within an effective region; and/or
providing a second gap structure between the top electrode and the piezoelectric layer of the second bulk acoustic wave resonator within the effective region.

21. The method according to any one of claims 9 to 20, further comprising:
providing a protrusion structure and/or recess structure near a boundary of an effective region of the first bulk acoustic wave resonator and/or the second bulk acoustic wave resonator.

22. The method according to any one of claims 9 to 20, wherein in the configuring the thickness of the second piezoelectric layer of the second bulk acoustic wave resonator to be smaller than the thickness of the first piezoelectric layer of the first bulk acoustic wave resonator, a target surface is bombarded with a particle beam to adjust a thickness of a target piezoelectric layer of the first piezoelectric layer and the second piezoelectric layer.

23. The method according to claim 22, wherein a thickness range of the target piezoelectric layer removed by the particle beam bombardment is 7 Å to 10000 Å.

24. A filter, comprising the bulk acoustic wave resonator assembly according to any one of claims 1 to 8, wherein two bulk acoustic wave resonators of at least one the bulk acoustic wave resonator assembly have different electromechanical coupling coefficients.

25. The filter according to claim 24, wherein the two bulk acoustic wave resonators in the at least one bulk acoustic wave resonator assembly have a same frequency, or a frequency difference between frequencies of the two bulk acoustic wave resonators is configured to be a predetermined value.

26. An electronic device, comprising the filter according to claim 24 or 25 or the bulk acoustic wave resonator assembly according to any one of claims 1 to 8.
